(19) Europäisches Patentamt / European Patent Office / Office européen des brevets

(11) **EP 3 650 875 B1**

(12) **FASCICULE DE BREVET EUROPEEN**

(45) Date de publication et mention de la délivrance du brevet:
**30.09.2020 Bulletin 2020/40**

(51) Int Cl.:
**G01R 31/327** (2006.01)

(21) Numéro de dépôt: **19202452.9**

(22) Date de dépôt: **10.10.2019**

(54) **PROCEDE DE TEST D'UN APPAREIL DE PROTECTION ELECTRIQUE ET APPAREIL DE PROTECTION METTANT EN OEUVRE UN TEL PROCEDE**

VERFAHREN ZUM TESTEN VON EINER ELEKTRISCHEN SCHUTZEINRICHTUNG UND ELEKTRISCHE SCHUTZEINRICHTUNG, DIE EIN SOLCHES VERFAHREN DURCHFÜHRT

METHOD FOR TESTING AN ELECTRICAL PROTECTION UNIT AND PROTECTION UNIT IMPLEMENTING SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.11.2018 FR 1871416**

(43) Date de publication de la demande:
**13.05.2020 Bulletin 2020/20**

(73) Titulaire: **Schneider Electric Industries SAS**
**92500 Rueil Malmaison (FR)**

(72) Inventeur: **BERNARD, Jean-Baptiste**
**38050 GRENOBLE Cedex 09 (FR)**

(74) Mandataire: **Tripodi, Paul**
**Schneider Electric Industries SAS**
**Service Propriété Industrielle**
**World Trade Center / 38EE1**
**5 Place Robert Schuman**
**38050 Grenoble Cedex 09 (FR)**

(56) Documents cités:
**US-A1- 2009 040 666     US-A1- 2012 154 957**

# EP 3 650 875 B1

**Description**

**Domaine technique**

La présente invention concerne un procédé de test du fonctionnement d'un appareil de protection d'un réseau électrique, tel qu'un disjoncteur, un relais de protection différentielle ou un interrupteur. L'invention concerne également un appareil de protection d'un réseau mettant en œuvre un tel procédé.

**Etat de la technique**

Les appareils de protection électrique sont largement utilisés dans les installations électriques afin de protéger les biens et les personnes contre des défauts électriques. Ces appareils de protection ont pour fonction, entre autres, d'interrompre l'alimentation électrique d'une portion défaillante du circuit électrique dès qu'un défaut est détecté afin d'isoler la portion défaillante du reste du circuit électrique. Le défaut détecté peut être un court-circuit, une surcharge, un défaut d'isolement à la terre ou un défaut différentiel. Ces appareils de protection disposent généralement d'un moyen de test permettant de vérifier leur bon fonctionnement. Pour cela, un signal de test ayant les caractéristiques du défaut faisant l'objet de la protection, est appliqué à l'appareil de protection afin de tester la capacité dudit appareil à détecter le défaut. Par exemple, un appareil de protection différentielle de calibre 300 mA est testé par une application d'un courant de test dont l'amplitude maximale peut atteindre 2,5 fois la valeur du calibre soit 750 mA.

La réduction du volume des appareils de protection demandée pour intégrer un nombre plus important d'appareil de contrôle et de protection électrique dans un tableau ou une armoire électrique ou encore l'intégration de nouvelles fonctionnalités dans un appareil de protection présente l'inconvénient, entre autres, d'un accroissement de l'échauffement interne des appareils. En conséquence, lesdits appareils doivent consommer le moins d'énergie possible afin de limiter l'auto-échauffement. Cette contrainte de consommation d'énergie est particulièrement importante en phase de test puisque l'énergie mise en œuvre pour le test est beaucoup plus importante que l'énergie nécessaire au fonctionnement de l'appareil. En reprenant l'exemple précédent, l'appareil de protection doit pouvoir fournir un courant de test dont l'amplitude peut aller jusqu'à 750 mA.

On connait le brevet US 5 371 646 décrivant un montage permettant de limiter la durée du test à la stricte durée nécessaire à l'ouverture du circuit électrique. Cependant, l'énergie nécessaire au test étant prélevée sur le réseau électrique, la puissance demandée est importante : par exemple, pour un réseau 400 Volt/50 Hz, un tel test nécessite une puissance de 120 Watt pour un calibre de 300 mA. Bien que le test dure très peu de temps, l'énergie dissipée dans le produit en test n'est pas négligeable.

On connait la demande de brevet EP 1 936 771 A1 portant sur un moyen de test d'un dispositif différentiel consistant à sélectionner un calibre de fonctionnement minimum et sélectionner une temporisation minimale. Cette solution est avantageuse quand elle est appliquée à un dispositif comportant plusieurs calibres, par exemple 30 mA, 100 mA et 300 mA puisque le test sera effectué sur le calibre 30 mA. En revanche, cette solution ne peut s'appliquer à un appareil n'ayant qu'un seul calibre, par exemple 300 mA.

La demande de brevet FR 17 55699 décrit une méthode de test d'un appareil de protection sans provoquer une ouverture du circuit électrique sur lequel est installé l'appareil de protection. Cette solution est très économe en énergie mais, par principe, ne teste pas l'ouverture du circuit électrique faisant l'objet de la protection. La demande de brevet US 2009/040666 A1 décrit un interrupteur comprenant un circuit de test. La demande de brevet US 2012/154957 A1 décrit un circuit de contrôle de capacité et un circuit de surveillance de courant utilisables avec un circuit d'appareil de protection.

**Exposé de l'invention**

La présente invention vise donc à remédier à ces inconvénients en permettant de tester le fonctionnement d'un appareil de protection, quel que soit le calibre sélectionné, sans nécessiter une surconsommation d'énergie importante par rapport au fonctionnement nominal.

Pour cela, l'invention a pour objet un procédé de test du fonctionnement d'un appareil de protection d'un réseau électrique, ledit appareil comportant :

- un capteur de courant fournissant un signal représentatif d'un courant électrique de défaut circulant dans, au moins, un conducteur électrique,
- un circuit convertisseur connecté, en entrée au capteur de courant pour recevoir le signal représentatif du courant de défaut, et connecté en sortie à un condensateur, ledit circuit convertisseur étant agencé pour convertir le signal représentatif du courant de défaut en une tension condensateur et également agencé pour charger le condensateur à ladite tension condensateur,

- un circuit de détection, connecté au condensateur, pour comparer la tension condensateur aux bornes du condensateur à une tension de seuil prédéterminée et activer une sortie de commande quand la tension condensateur aux bornes du condensateur est supérieure à la tension de seuil,
- un premier circuit générateur pour générer un courant de test dans le capteur de courant,
- un second circuit générateur pour générer un courant de charge du condensateur, ledit procédé comportant :

une première séquence de test pour tester le capteur de courant, le circuit convertisseur et le condensateur, au moyen du premier circuit générateur et, quand la première séquence de test est positive,
une deuxième séquence de test pour tester le circuit de détection au moyen du second circuit générateur et pour activer la sortie de commande quand la deuxième séquence de test est positive.

Avantageusement, la première séquence de test comporte :

- une étape d'une première mesure de tension aux bornes du condensateur,
- une étape de génération du courant de test dans le capteur de courant pendant une première temporisation, et
- une étape d'une seconde mesure de tension aux bornes du condensateur.

Avantageusement, la première temporisation est déterminée pour que la seconde mesure de tension soit inférieure à la tension de seuil.

De préférence, la première temporisation est déterminée en fonction :

- de la première mesure de tension aux bornes du condensateur,
- d'une valeur d'une première tension cible prédéterminée,
- de la capacité du condensateur, et
- de l'amplitude du courant de test.

Avantageusement, la valeur de la première tension cible est inférieure à la tension de seuil.

Préférentiellement, la première temporisation est calculée selon l'équation :

[Math 1]

$$Tempo\_1 = \frac{(V\_cap1 - V\_s1)\, x\, C}{I\_tst1}$$

dans laquelle,

Tempo_1 est la première temporisation,
V_cap1 est la première mesure de tension aux bornes du condensateur,
V_s 1 est la valeur de la première tension cible,
C est la capacité du condensateur, et
I_tst1 est l'amplitude du courant de test.

Avantageusement, la première séquence de test est positive quand la différence entre la seconde mesure de tension et la première mesure de tension est supérieure à un deuxième seuil prédéterminé.

De préférence, la seconde séquence de test comporte une étape de génération du courant de charge du condensateur au moyen du second circuit générateur pendant une seconde temporisation prédéterminée.

Préférentiellement, la seconde temporisation est déterminée en fonction :

- de la seconde mesure de tension,
- d'une seconde tension cible prédéterminée,
- de la valeur de la capacité du condensateur, et
- de l'amplitude du courant de charge du condensateur.

De préférence, la seconde temporisation est calculée selon l'équation :

[Math 2]

$$Tempo\_2 \ = \frac{(V\_s2 \ - \ V\_cap2) \ x \ C}{I\_tst2}$$

dans laquelle,

Tempo_2 est la seconde temporisation,
V_s2 est la seconde tension cible,
V_cap2 est la seconde mesure de tension,
C est la valeur de la capacité du condensateur, et
I_tst2 est l'amplitude du courant de charge du condensateur.

Avantageusement, la valeur de la seconde tension cible est comprise entre 1 fois et 1,2 fois la tension de seuil.

L'invention porte également sur un appareil de protection d'un réseau électrique, ledit appareil comportant :

- un capteur de courant fournissant un signal représentatif d'un courant électrique de défaut circulant dans, au moins, un conducteur électrique,
- un circuit convertisseur connecté, en entrée au capteur de courant, et en sortie à un condensateur, ledit circuit convertisseur étant agencé pour convertir le signal représentatif du courant de défaut en une tension condensateur et pour charger ledit condensateur à ladite tension,
- un circuit de détection, connecté au condensateur, pour comparer la tension condensateur aux bornes du condensateur à une première tension de seuil prédéterminée et activer une sortie de commande quand la tension aux bornes du condensateur est supérieure à la tension de seuil,
- un premier circuit générateur pour générer un courant de test dans le capteur de courant,
- un circuit de mesure, connecté au condensateur, pour mesurer la tension condensateur aux bornes du condensateur,
- un second circuit générateur pour générer un courant de charge pour charger le condensateur, et
- un circuit de traitement connecté au premier circuit générateur pour commander la génération du courant de test, connecté au second circuit générateur pour commander la génération du courant de charge et connecté au circuit de mesure pour recevoir la mesure de la tension condensateur aux bornes du condensateur, ledit circuit de traitement comportant des circuits pour exécuter le procédé de test décrit précédemment.

Avantageusement le circuit convertisseur comporte une résistance de charge et un circuit de redressement du signal représentatif (Is) du courant de défaut.

Préférentiellement, l'appareil de protection comporte :

- un interrupteur de courant pour établir ou pour interrompre la circulation d'un courant électrique dans, au moins, un conducteur de courant,
- un actionneur, relié à la sortie de commande du circuit de détection, ledit actionneur actionnant l'ouverture de l'interrupteur de courant quand la sortie de commande est activée.

Avantageusement, le capteur de courant est un capteur du courant différentiel circulant dans, au moins, deux conducteurs électriques.

Brève description des dessins

Les dessins annexés illustrent l'invention :

[Fig 1] La figure 1 représente sous forme d'un schéma bloc, un dispositif de test d'un appareil de protection d'un réseau électrique.

[Fig 2] La figure 2 représente un organigramme d'un procédé de test d'un appareil de protection comportant un dispositif de test selon l'invention.

[Fig 3A]

[Fig 3B]

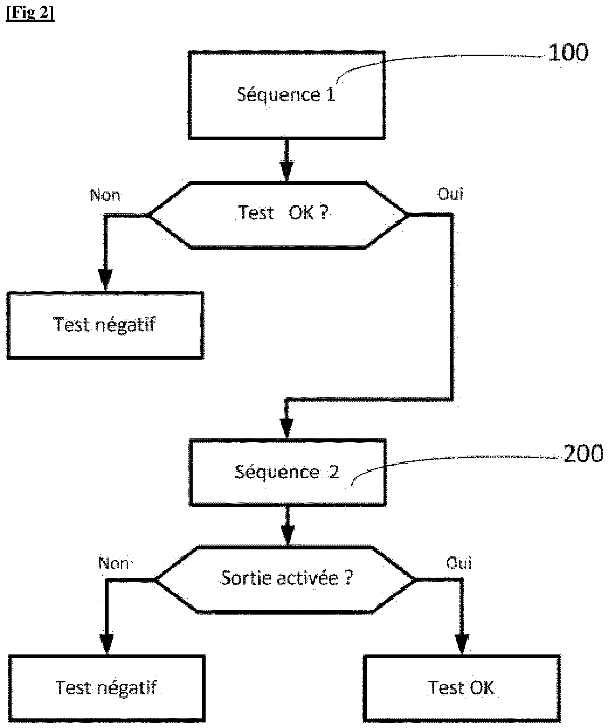

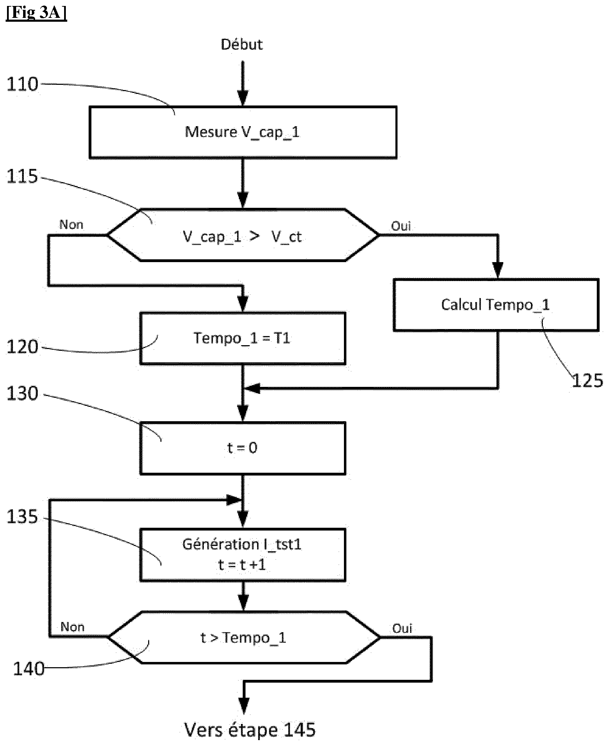

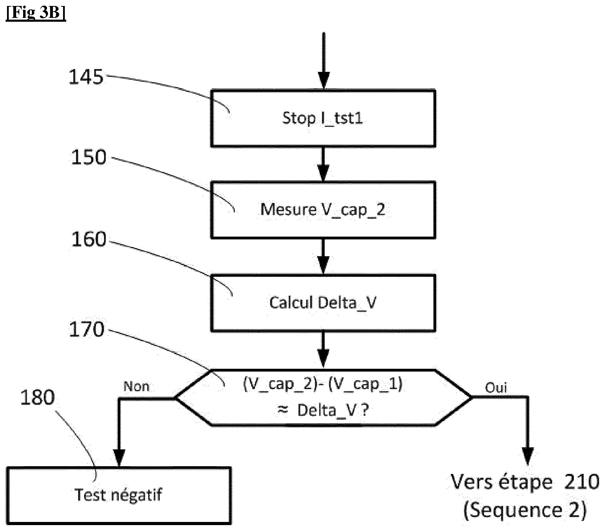

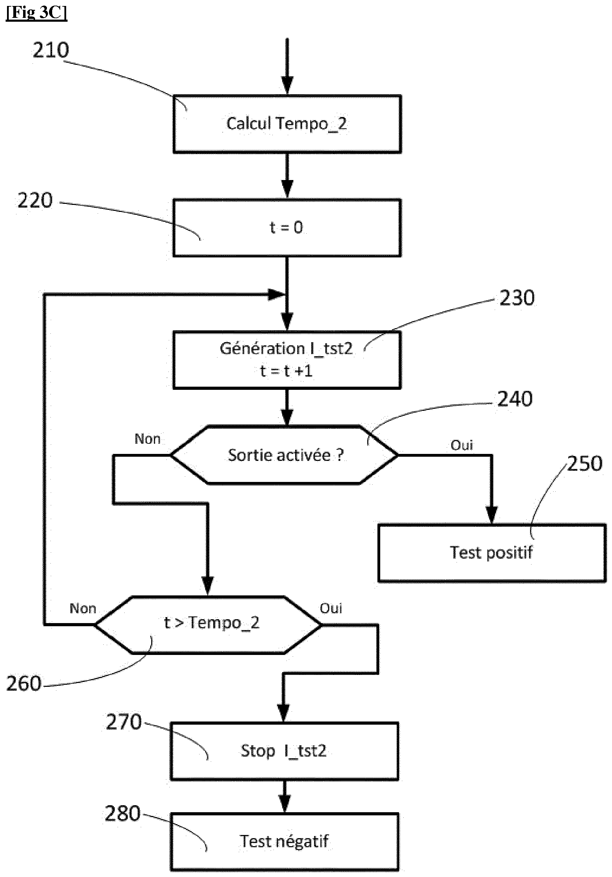

[Fig 3C] Les figures 3A, 3B et 3C représentent des détails de l'organigramme du procédé de test représenté en figure 2.

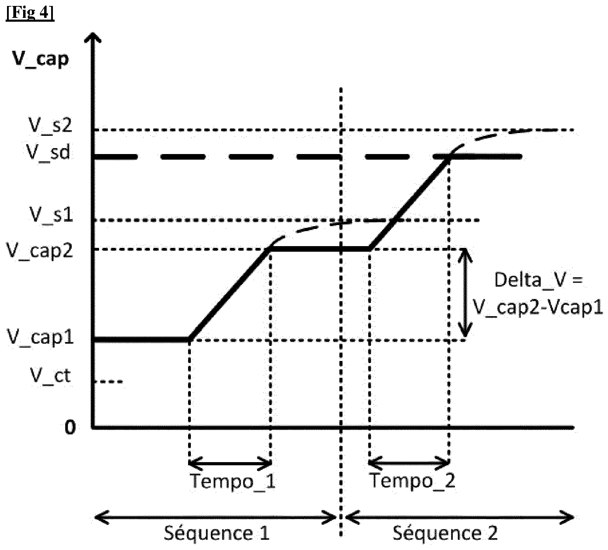

[Fig 4] La figure 4 illustre, au moyen d'un graphe, des niveaux de tension mesurés et des niveaux de seuils prédéfinis ou calculés au cours de l'exécution du procédé de test.

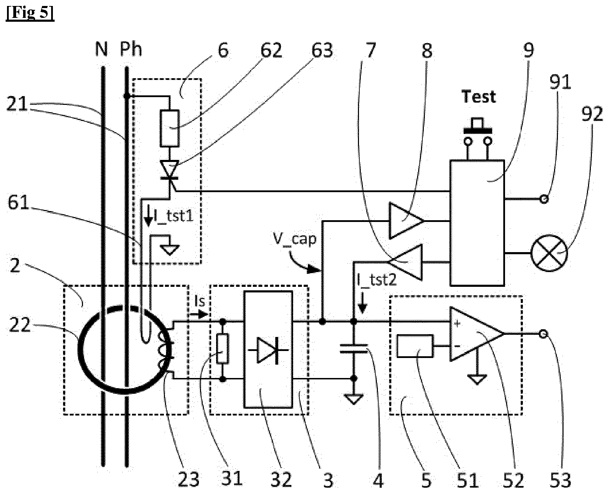

[Fig 5] La figure 5 est une représentation schématique du dispositif de test de l'invention.

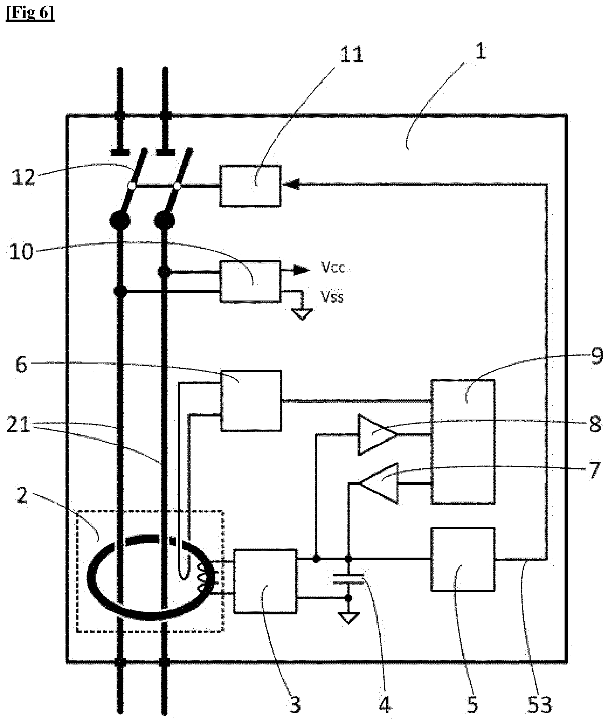

[Fig 6] La figure 6 est une représentation schématique d'un appareil de protection comportant le dispositif de test de l'invention.

## Description détaillée de modes de réalisation préférés

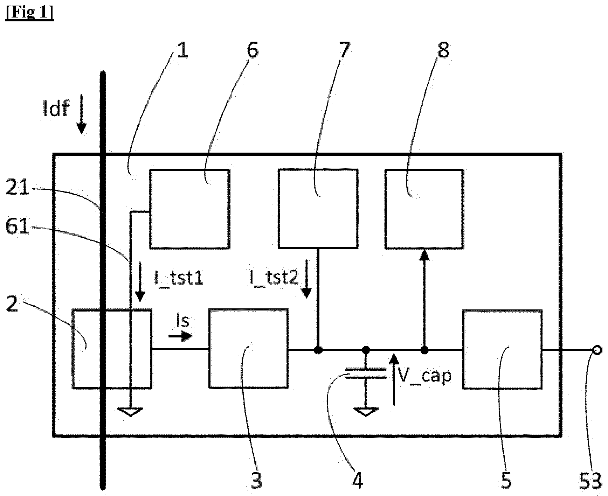

La figure 1 représente sous forme d'un schéma bloc, un dispositif de test d'une chaîne de mesure de courant d'un appareil de protection électrique 1 selon un mode de réalisation préférentiel de l'invention. Ledit appareil de protection 1 comporte un capteur de courant 2 agencé pour fournir un signal Is représentatif d'un courant électrique de défaut Idf circulant dans, au moins, un conducteur électrique 21. Le capteur de courant 2 est, préférentiellement, un capteur de courant différentiel et, dans ce cas, au moins deux conducteurs électrique 21 sont utilisés. Une sortie du capteur de courant 2 est connectée à une entrée d'un circuit convertisseur 3. Ledit convertisseur 3, comportant une entrée et une sortie, est agencé pour convertir le signal représentatif du courant de défaut (Is) reçu sur son entrée en une tension condensateur V_cap et pour charger un condensateur 4, de capacité C, connecté sur sa sortie, à ladite tension condensateur V_cap. La tension aux bornes du condensateur 4 est ainsi représentative du courant électrique de défaut Idf. Le condensateur 4 est connecté à une entrée d'un circuit de détection 5. Le circuit de détection 5 compare la tension condensateur V_cap reçue sur son entrée à une tension de seuil V_sd prédéterminée et active une sortie de commande 53 quand la tension condensateur V_cap est supérieure à la tension de seuil V_sd. La tension de seuil V_sd est liée à une limite dénommée calibre de l'appareil de protection électrique. Le calibre peut être prédéfini à 30 mA, 100 mA, 300 mA ou toute autre valeur permettant d'offrir une protection adaptée à l'installation électrique dans laquelle est implanté l'appareil de protection. La tension de seuil V_sd est la tension condensateur V_cap obtenue quand le courant électrique de défaut Idf est égal au calibre de l'appareil de protection. La sortie de commande 53 est donc activée quand le courant électrique de défaut Idf est supérieur au calibre de l'appareil de protection.

L'appareil de protection 1 doit pouvoir être testé afin de vérifier son bon fonctionnement. Pour cela, un dispositif et un procédé de test sont mis en œuvre afin de tester le fonctionnement de l'ensemble capteur de courant 2, convertisseur 3, condensateur 4, circuit de détection 5 et sortie de commande 53. Pour cela, un premier circuit générateur 6 est connecté au capteur de courant 2 pour générer un courant de test I_tst1 dans le capteur de courant 2. Le courant de test I_tst1 doit être représentatif d'un courant de défaut Idf. Cependant, dans le cas d'un test d'un appareil de calibre 300 mA, le premier circuit générateur 6 doit fournir un courant d'amplitude supérieure à 300 mA. Pour cela, le premier circuit générateur 6 doit comporter des composants dimensionnés pour dissiper plusieurs Watts ce qui pose un premier problème d'élévation de la température interne de l'appareil de protection 1 et un second problème d'encombrement lié au volume des composants du générateur, tout particulièrement quand ledit appareil est d'un volume réduit. Il est possible de réduire le courant de test I_tst1 en utilisant, par exemple, un capteur de courant 2 de type transformateur de courant, la réduction du courant de test I_tst1 nécessaire étant inversement proportionnelle au nombre de spires constituant l'enroulement de test du capteur. Cette solution, connue de l'art antérieur, nécessite généralement une construction du transformateur de courant et de son enroulement de test adaptée au calibre de l'appareil de protection ou à une étendue limitée de calibres. Cette solution génère donc autant de variantes industrielles que de calibres ce qui accroit le coût de fabrication.

L'objet de l'invention, représenté en figure 2 sous forme d'un organigramme, est un procédé de test comportant une première séquence de test 100 pour tester, dans un premier temps le capteur de courant 2, le circuit convertisseur 3 et le condensateur 4 en utilisant moins d'énergie que pour un test mettant en œuvre un courant de test supérieur au calibre de l'appareil. Au cours de ladite première séquence de test 1, la tension condensateur V_cap reste inférieure à la tension de seuil V_sd de manière à ne pas activer la sortie de commande 53. Quand la première séquence de test est positive, le procédé se poursuit par une seconde séquence de test 200 pour tester le condensateur 4, le circuit de détection 5 et pour activer la sortie de commande 53 quand la deuxième séquence de test est positive. Le fractionnement innovant des opérations de test en deux séquences de test, mettant en œuvre des signaux et des critères de test différents, permet de tester tous les circuits et les composants de manière fiable, sans générer de surconsommation d'énergie et donc sans générer d'échauffement significatif.

Les figure 3A et 3B représentent la première séquence de test 100 sous forme d'un organigramme détaillé. Ladite première séquence de test 100 commence par une étape 110 de première mesure de tension condensateur V_cap1 aux bornes du condensateur 4. Le procédé peut se poursuivre par une étape 120 d'initialisation d'une première temporisation Tempo_1 à une première durée prédéterminée T1. Préférentiellement, une étape 115 de comparaison de la première mesure de tension condensateur V_cap1 à une tension de contrôle V_ct prédéterminée est effectué après l'étape de mesure 110. Quand la première mesure de tension condensateur V_cap1 est supérieure à la tension de contrôle V_ct, alors un calcul de la première temporisation Tempo_1 est effectué au cours d'une étape 125. La première temporisation Tempo_1 est calculée de manière à ce que la tension aux bornes du condensateur 4, à la fin de la temporisation Tempo_1, atteigne une tension cible V_s1, inférieure à la tension de seuil V_sd. Cette particularité permet une vérification du bon fonctionnement du capteur de courant 2, du circuit convertisseur 3 et du condensateur 4 sans activer la sortie de commande 53. La valeur de la première tension cible V_s1 est inférieure à la tension de seuil V_sd. Préférentiellement, la valeur de ladite première tension cible V_s1 est comprise entre 0,1 et 0,9 fois la tension de seuil V_sd. Elle est fonction de la valeur du calibre de l'appareil et de l'amplitude du courant de test à générer.

La valeur de la première temporisation Tempo_1 est déterminée en fonction :

- de la valeur de la première mesure de tension V_cap1,
- de la valeur de la première tension cible V_s1,
- de la valeur de la capacité C du condensateur 4, et
- de la valeur de l'amplitude du courant de test I_tst1.

Préférentiellement la valeur de la première temporisation Tempo_1 est calculée selon l'équation suivante :

[Math 3]

$$Tempo\_1 \; = \frac{(V\_cap1 \; - \; V\_s1) \, x \, C}{I\_tst1}$$

L'étape 120 d'initialisation de la première temporisation Tempo_1 ou l'étape 125 de calcul de ladite première temporisation Tempo_1 sont suivies d'une étape 130 d'initialisation à zéro d'un chronomètre t puis par une étape 135 d'incrémentation du chronomètre t et de la fourniture du courant de test I_tst1 par le premier circuit générateur 6. Ensuite, le temps t écoulé est comparé à la première temporisation Tempo_1 au cours d'une étape de comparaison 140. Tant que le temps t est inférieur à la première temporisation Tempo_1, le procédé reste dans les étapes de fourniture du courant de test I_tst1. Dès que le temps t écoulé est supérieur à la première temporisation Tempo_1, le procédé passe à une étape 145 au cours de laquelle la fourniture du courant de test I_tst1 est stoppée puis à une étape 150 de seconde mesure de tension V_cap2 aux bornes du condensateur 4. Ensuite, un calcul d'écart théorique Delta_V est effectué au cours d'une étape 160. L'écart théorique Delta_V correspond à l'accroissement théorique de la tension V_cap aux bornes du condensateur 4 due à la présence du courant de test I_tst1 pendant la durée de la première temporisation Tempo_1.

Préférentiellement, la valeur de l'écart théorique Delta_V est calculée selon l'équation suivante :

[Math 4]

$$Delta\_V \quad = \frac{1}{C} \, x \, I\_tst1 \, x \, Tempo\_1$$

Une comparaison entre l'écart théorique Delta_V et la différence de potentiel entre la seconde mesure de tension V_cap2 et la première mesure de tension V_cap1 est effectuée au cours d'une étape de comparaison 170. Quand l'égalité n'est pas atteinte, en particulier quand la différence de potentiel entre la seconde mesure de tension V_cap2 et la première mesure de tension V_cap1 est inférieure à l'écart théorique Delta_V, alors le test est considéré comme négatif à une étape 180. En revanche, quand l'égalité est respectée, la première séquence de test 100 est jugée positive et le procédé se poursuit par la seconde séquence de test 200. Dans un mode de réalisation préféré, l'égalité est considérée comme respectée quand la différence de tension entre V_cap2 et V_cap1 est comprise entre l'écart théorique Delta_V -20% et Delta_V +20%.

La figure 3C représentent la seconde séquence de test 200 sous forme d'un organigramme détaillé. Ladite seconde séquence de test 200 commence par une étape 210 de calcul de la seconde temporisation Tempo_2. De manière analogue à la séquence 1, la seconde temporisation Tempo_2 peut être prédéfinie à une durée suffisante pour obtenir une activation de la sortie de commande 53. Préférentiellement, la seconde temporisation Tempo_2 est calculée de manière à vérifier la précision du seuil d'activation de la sortie de commande 53 par le circuit de détection 5. Pour cela, la seconde temporisation Tempo_2 est calculée de manière à ce que la tension aux bornes du condensateur 4 atteigne une seconde tension cible V_s2 sensiblement supérieure à la tension de seuil V_sd pour obtenir l'activation de la sortie de commande 53. On entend par « sensiblement supérieure » le fait que la valeur de ladite seconde tension cible V_s2 est comprise préférentiellement entre 1 et 1,5 fois la tension de seuil V sd. Une telle limitation de plage permet de vérifier la précision de basculement du circuit de détection 5. Par exemple, dans un mode de réalisation particulier, la tension cible V_s2 est égale à 1,2 fois la tension de seuil V_sd. Le circuit de détection 5 active ainsi la sortie de commande, dans le pire cas, lorsque la tension condensateur V_cap aux bornes du condensateur 4 dépasse de 20% la tension de seuil V_sd. On vérifie ainsi que le seuil d'activation de la sortie de commande n'a pas dérivé de plus de 20% par rapport au seuil d'activation attendu.

La valeur de la seconde temporisation Tempo_2 est déterminée en fonction :

- de la valeur de la seconde mesure de tension V_cap2,
- de la valeur de la seconde tension cible V_s2,
- de la valeur de la capacité C du condensateur 4, et
- de la valeur de l'amplitude d'un courant de charge I_tst2 fournit par un second circuit générateur 7.

Préférentiellement la valeur de la seconde temporisation Tempo_2 est calculée selon l'équation suivante :

[Math 5]

$$Tempo\_2 = \frac{(V\_s2 - V\_cap2) \; x \; C}{I\_tst2}$$

L'étape 210 de calcul de la seconde temporisation Tempo_2 est suivie d'une étape 220 d'initialisation à zéro du chronomètre t puis par une étape 230 de d'incrémentation du chronomètre t et de la fourniture du courant de charge I_tst2 par le second circuit générateur 7. Le courant de charge I_tst2 va charger le condensateur 4 afin de faire monter la tension V_cap aux bornes dudit condensateur 4 jusqu'à la valeur de la seconde tension cible V_s2. Ladite tension cible V_s2 est légèrement supérieure à la tension de seuil V_sd et, par conséquent, lorsque la tension V_cap aux bornes du condensateur 4 est égale à la tension de seuil V_sd, à l'étape 240, le circuit de détection 5 active la sortie de commande 53. Le procédé se termine par une étape 250 de signalisation de test positif.

Le temps t écoulé est comparé à la seconde temporisation Tempo_2 au cours d'une étape de comparaison 260. Tant que le temps t est inférieur à la seconde temporisation Tempo_2, le procédé reste dans l'étape 230 de fourniture du courant de test I_tst1 et d'incrémentation du chronomètre t. Dès que le temps t écoulé est supérieur à la seconde temporisation Tempo_2, le procédé passe à une étape 270 au cours de laquelle la fourniture du courant de test I_tst2 est stoppée puis à une étape 280 pour une signalisation d'un test négatif : en effet, au cours de la durée de la seconde temporisation Tempo_2, la tension V_cap aux bornes du condensateur 4 n'a pas été égale ou supérieure à la tension de seuil V_sd, et donc la sortie de commande 53 n'a pas été activée.

Le graphe représenté en figure 4 illustre des niveaux de tension aux bornes du condensateur 4 et des niveaux de seuils prédéfinis ou calculés au cours de l'exécution complète du procédé de test. A l'étape 110 de la première séquence, la tension aux bornes du condensateur 4 est égale à V_cap1. La tension V_cap1 étant supérieure à la tension de contrôle V_ct, le procédé calcule la première temporisation Tempo_1 au cours de l'étape 125 puis, à l'étape 135, commande la fourniture du courant de test I_tst1 par le premier circuit générateur 6 et l'incrémentation du chronomètre t. La tension aux bornes du condensateur 4 s'accroit et tend vers la première tension cible V_s1. Cependant, la fin de la première temporisation Tempo_1 fige la tension aux bornes du condensateur 4 à la valeur V_cap2. Le capteur de courant 2, le circuit convertisseur 3 et le condensateur 4 ayant fonctionné correctement, la différence de potentiel entre la seconde mesure de tension V_cap2 et la première mesure de tension V_cap1 est sensiblement égale à l'écart théorique Delta_V. Le procédé passe à la seconde séquence de test 200 au cours de laquelle le courant de charge I_tst2 est fourni par le second circuit générateur 7 pendant la seconde temporisation Tempo_2. La tension aux bornes du condensateur 4 s'accroit et tend vers la seconde tension cible V_s2. Cependant, quand la tension aux bornes du condensateur 4 passe au-dessus de la tension de seuil V_sd, le circuit de détection 5 active la sortie de commande 53, le test est positif et le procédé est arrêté.

L'invention a également pour objet un appareil de protection électrique 1 offrant préférentiellement une protection contre les défauts électriques de type défaut différentiel, par exemple un disjoncteur, un relais de protection ou un interrupteur. Un dispositif de test d'un tel appareil de protection 1 est représenté schématiquement en figure 5. Un tel appareil de protection 1 comporte :

- un capteur de courant 2 fournissant un signal représentatif Is d'un courant électrique de défaut Idf circulant dans, au moins, un conducteur électrique 21,
- un circuit convertisseur 3 connecté, en entrée au capteur de courant 2, et en sortie à un condensateur 4, ledit circuit convertisseur 3 étant agencé pour convertir le signal représentatif du courant de défaut Is en une tension condensateur V_cap et pour charger ledit condensateur 4 à ladite tension V-cap,
- un circuit de détection 5, connecté au condensateur 4, pour comparer la tension condensateur V_cap aux bornes du condensateur 4 à une première tension de seuil V_sd prédéterminée au moyen d'un comparateur 52 et activer une sortie de commande 53 quand la tension aux bornes du condensateur 4 est supérieure à la tension de seuil V_sd fournie par une référence de tension 51,

- un premier circuit générateur 6 pour générer un courant de test I_tst1 dans le capteur de courant 2,
- un circuit de mesure 8, connecté au condensateur 4, pour mesurer la tension condensateur V_cap aux bornes du condensateur 4 et fournir une mesure de ladite tension V_cap,
- un second circuit générateur 7 pour générer un courant de charge I_tst2 pour charger le condensateur 4, et
- un circuit de traitement 9 connecté au premier circuit générateur 6 pour commander la génération du courant de test I_tst1, ledit circuit de traitement étant connecté au second circuit générateur 7 pour commander la génération du courant de charge I_tst2 et connecté au circuit de mesure 8 pour recevoir la mesure de la tension condensateur V_cap aux bornes du condensateur 4. Optionnellement, une ligne de communication 91 est destinée à transmettre des informations d'état de l'appareil de protection 1 et/ou recevoir des commandes et un indicateur 92 permet d'afficher des informations sur l'état de l'appareil de protection 1.

Le circuit de traitement 9 comporte des circuits tels que des portes logiques, microprocesseur, microcontrôleur ou ASIC, pour exécuter le procédé de test décrit précédemment.

Le condensateur 4 a préférentiellement une capacité C comprise entre 0,5 et 10 microFarad.

Le capteur de courant 2 comporte préférentiellement un circuit magnétique 22 et un enroulement secondaire 23 pour fournir le signal Is représentatif du courant électrique de défaut Idf. Préférentiellement, le capteur de courant 2 est un capteur de courant différentiel destiné à détecter une différence d'amplitude du courant circulant dans, au moins, deux conducteurs électriques 21.

Le circuit convertisseur 3 comporte une résistance de charge 31, destinée à ajuster le calibre de l'appareil de protection 1. Un circuit de redressement 32 est agencé pour redresser le signal représentatif Is du courant électrique de défaut Idf délivré par le capteur de courant 2 en une tension continue V_cap et pour charger le condensateur 4 à ladite tension V_cap.

Le premier circuit générateur 6, représenté en figure 5, est constitué d'une résistance de limitation 62 et d'un thyristor 63. La gâchette du thyristor est connectée au circuit de traitement 9 pour commander la génération du courant de test I_tst1 dans le capteur de courant 2. Le courant de test I_tst1 est prélevé sur un des conducteurs de courant 21, par exemple le conducteur de phase Ph. Le courant de test est limité par la résistance de limitation 62 et circule dans un conducteur 61 passant par le capteur de courant 2. Par exemple, le courant de test I_tst1 est égal à 50 mA pour un calibre de 300 mA. En réduisant ainsi le courant de test du capteur d'un facteur 15, soit 750/50, l'énergie dissipée lors de la mise en œuvre du test est divisée par 225 en comparaison avec un test pour lequel le courant de test I_tst1 serait égal au courant de test égal à 750 mA. En conséquence, la taille des composants utilisés pour générer les signaux de test est réduite dans les mêmes proportions, ce qui représente un avantage significatif du procédé de test selon l'invention. Le mode de réalisation du premier circuit générateur 6 représenté en figure 5 est préférentiel, cependant d'autres modes de réalisation peuvent être envisagés.

L'appareil de protection 1 est destiné à protéger une installation électrique contre des défauts électriques en effectuant une ouverture du circuit électrique surveillé. Pour cela, l'appareil de protection 1, représenté sous forme schématique en figure 6, comporte :

- un interrupteur de courant 12, connecté en série avec au moins, un conducteur de courant 21, ledit interrupteur 12 étant agencé pour établir ou pour interrompre la circulation du courant électrique dans le, au moins, un conducteur de courant 21,
- un actionneur 11, relié à la sortie de commande 53 du circuit de détection 5, ledit actionneur 11 actionnant l'ouverture de l'interrupteur de courant 12 pour interrompre la circulation du courant électrique quand la sortie de commande 53 est activée.

Dans un mode de réalisation préférentiel, l'actionneur 11 dispose d'un seuil de fonctionnement prédéterminé, il intègre la fonction du circuit de détection 5.

Des circuits d'alimentation 10 fournissent une alimentation Vcc adaptée au circuit de traitement 9, au circuit de mesure 8, au second circuit générateur 7 et au circuit de détection 5. L'alimentation et l'ensemble des circuits sont référencés par rapport à un potentiel de référence Vss. Les circuits d'alimentation 10 sont connectés préférentiellement aux conducteurs électrique 21 pour prélever l'énergie nécessaire au fonctionnement des différents circuits alimentés.

Le procédé de test faisant l'objet de l'invention permet un test exhaustif et précis des circuits et composants. Un tel procédé limite très fortement la consommation d'énergie nécessaire au test et donc limite l'échauffement des composants grâce au fractionnement des opérations de test en deux séquences de test, chaque opération de test mettant en œuvre un générateur spécifique délivrant le minimum d'énergie nécessaire au test. Un tel procédé permet également de vérifier que les circuits n'ont pas dérivé dans leur fonctionnement. Par exemple, si le premier circuit générateur 6 délivre un courant de test d'amplitude différente de I_tst1 ou si la valeur de la capacité C a dérivé, alors la différence de potentiel V_cap2 - V_cap1 sera différente de l'écart théorique Delta_V et le test sera négatif. Enfin, la valeur du calibre n'a pas d'impact fort sur le procédé de test ni sur le choix des composants et circuits mis en œuvre, un tel procédé peut donc être mis en œuvre dans une très large gamme de produits de protection.

**Revendications**

1. Procédé de test du fonctionnement d'un appareil de protection (1) d'un réseau électrique, ledit appareil comportant :

   - un capteur de courant (2) fournissant un signal représentatif (Is) d'un courant électrique de défaut (Idf) circulant dans, au moins, un conducteur électrique (21),
   - un circuit convertisseur (3) connecté, en entrée au capteur de courant (2) pour recevoir le signal représentatif (Is) du courant de défaut (Idf), et connecté en sortie à un condensateur (4), ledit circuit convertisseur (3) étant agencé pour convertir le signal représentatif du courant de défaut (Is) en une tension condensateur (V_cap) et pour charger le condensateur (4) à ladite tension condensateur (V_cap),
   - un circuit de détection (5), connecté au condensateur (4), pour comparer la tension condensateur (V_cap) aux bornes du condensateur (4) à une tension de seuil prédéterminée (V_sd) et activer une sortie de commande (53) quand la tension condensateur (V_cap) aux bornes du condensateur (4) est supérieure à la tension de seuil (V_sd),
   - un premier circuit générateur (6) pour générer un courant de test (I_tst1) dans le capteur de courant (2),
   - un second circuit générateur (7) pour générer un courant de charge (I_tst2) du condensateur (4),

   où le procédé comporte:

   une première séquence de test (100) pour tester le capteur de courant (2), le circuit convertisseur (3) et le condensateur (4), au moyen du premier circuit générateur (6) et, quand la première séquence de test est positive, une deuxième séquence de test (200) pour tester le circuit de détection (5) au moyen du second circuit générateur (7) et pour activer la sortie de commande (53) quand la deuxième séquence de test est positive.

2. Procédé de test selon la revendication 1 **caractérisé en ce que** la première séquence de test (100) comporte :

   - une étape (110) d'une première mesure de tension (V_cap1) aux bornes du condensateur (4),
   - une étape (135) de génération du courant de test (I_tst1) dans le capteur de courant (2) pendant une première temporisation (Tempo_1), et
   - une étape (150) d'une seconde mesure de tension (V_cap2) aux bornes du condensateur (4).

3. Procédé de test selon la revendication 2 **caractérisé en ce que** la première temporisation (Tempo_1) est déterminée pour que la seconde mesure de tension (V_cap2) soit inférieure à la tension de seuil (V_sd).

4. Procédé de test selon l'une des revendications 2 ou 3 **caractérisé en ce que** la première temporisation (Tempo_1) est déterminée en fonction :

   - de la première mesure de tension (V_cap1) aux bornes du condensateur (4),
   - d'une valeur d'une première tension cible (V_s1) prédéterminée,
   - de la capacité (C) du condensateur (4), et
   - de l'amplitude du courant de test (I_tst1).

5. Procédé de test selon la revendication précédente **caractérisé en ce que** la valeur de la première tension cible (V_s1) est inférieure à la tension de seuil (V_sd).

6. Procédé de test selon l'une des revendications 4 ou 5 **caractérisé en ce que** la première temporisation (Tempo_1) est calculée selon l'équation :

[Math 6]

$$Tempo\_1 \ = \frac{(V\_cap1 \ - \ V\_s1) \ x \ C}{I\_tst1}$$

dans laquelle,

Tempo_1 est la première temporisation,
V_cap1 est la première mesure de tension aux bornes du condensateur (4),
V_s1 est la valeur de la première tension cible,
C est la capacité du condensateur (4), et
I_tst1 est l'amplitude du courant de test.

7. Procédé de test selon l'une quelconque des revendications 2 à 6 **caractérisé en ce que** la première séquence de test (100) est positive quand la différence entre la seconde mesure de tension (V_cap2) et la première mesure de tension (V_cap1) est supérieure à un deuxième seuil (Delta_V) prédéterminé.

8. Procédé de test selon l'une quelconque des revendications précédentes **caractérisé en ce que** ce que la seconde séquence de test (200) comporte une étape (240) de génération du courant de charge (I_tst2) du condensateur (4) au moyen du second circuit générateur (7) pendant une seconde temporisation (Tempo_2) prédéterminée.

9. Procédé de test selon la revendication précédente **caractérisé en ce que** la seconde temporisation (Tempo_2) est déterminée en fonction :

- de la seconde mesure de tension (V_cap2),
- d'une seconde tension cible (V_s2) prédéterminée,
- de la valeur de la capacité (C) du condensateur (4), et
- de l'amplitude du courant de charge (I_tst2) du condensateur (4).

10. Procédé de test selon la revendication précédente **caractérisé en ce que** la seconde temporisation (Tempo_2) est calculée selon l'équation :

[Math 7]

$$Tempo\_2 \ = \frac{(V\_s2 \ - \ V\_cap2) \ x \ C}{I\_tst2}$$

dans laquelle,

Tempo_2 est la seconde temporisation,
V_s2 est la seconde tension cible,
V_cap2 est la seconde mesure de tension,
C est la valeur de la capacité du condensateur (4), et
I_tst2 est l'amplitude du courant de charge du condensateur (4).

11. Procédé de test selon l'une des revendications 9 ou 10 **caractérisé en ce que** la valeur de la seconde tension cible (V_s2) est comprise entre 1 fois et 1,2 fois la tension de seuil (V_sd).

12. Appareil de protection (1) d'un réseau électrique, ledit appareil comportant :

- un capteur de courant (2) fournissant un signal représentatif (Is) d'un courant électrique de défaut (Idf) circulant dans, au moins, un conducteur électrique (21),
- un circuit convertisseur (3) connecté, en entrée au capteur de courant (2), et en sortie à un condensateur (4), ledit circuit convertisseur (3) étant agencé pour convertir le signal représentatif du courant de défaut (Is) en une tension condensateur (V_cap) et pour charger ledit condensateur (4) à ladite tension (V-cap),
- un circuit de détection (5), connecté au condensateur (4), pour comparer la tension condensateur (V_cap) aux bornes du condensateur (4) à une première tension de seuil (V_sd) prédéterminée et activer une sortie de commande (53) quand la tension aux bornes du condensateur (4) est supérieure à la tension de seuil (V_sd),
- un premier circuit générateur (6) pour générer un courant de test (I_tst1) dans le capteur de courant (2),

ledit appareil de protection (1) étant **caractérisé en ce qu'**il comporte :

- un circuit de mesure (8), connecté au condensateur (4), pour mesurer la tension condensateur (V_cap) aux bornes du condensateur (4),
- un second circuit générateur (7) pour générer un courant de charge (I_tst2) pour charger le condensateur (4), et
- un circuit de traitement (9) connecté au premier circuit générateur (6) pour commander la génération du courant de test (I_tst1), connecté au second circuit générateur (7) pour commander la génération du courant de charge (I_tst2) et connecté au circuit de mesure (8) pour recevoir la mesure de la tension condensateur (V_cap) aux bornes du condensateur (4), ledit circuit de traitement (9) comportant des circuits pour exécuter le procédé de test selon l'une des revendications 1 à 11.

13. Appareil de protection (1) selon la revendication précédente **caractérisé en ce que** le circuit convertisseur (3) comporte une résistance de charge (31) et un circuit de redressement (32) du signal représentatif (Is) du courant de défaut (Idf).

14. Appareil de protection (1) selon l'une des revendications 12 ou 13 **caractérisé en ce qu'**il comporte :

- un interrupteur de courant (12) pour établir ou pour interrompre la circulation d'un courant électrique dans, au moins, un conducteur de courant (21),
- un actionneur (11), relié à la sortie de commande (53) du circuit de détection (5), ledit actionneur (11) actionnant l'ouverture de l'interrupteur de courant (12) quand la sortie de commande (53) est activée.

15. Appareil de protection (1) selon l'une quelconque des revendications 12 à 14 **caractérisé en ce que** le capteur de courant (2) est un capteur du courant différentiel circulant dans, au moins, deux conducteurs électriques (21).

**Patentansprüche**

1. Verfahren zum Testen des Betriebs eines Schutzgeräts (1) eines elektrischen Netzes, wobei das Gerät umfasst:

- einen Stromsensor (2), der ein Signal (Is) abgibt, das für einen elektrischen Fehlerstrom (Idf) repräsentativ ist, der in, mindestens, einem elektrischen Leiter (21) fließt,
- eine Wandlerschaltung (3), die im Eingang mit dem Stromsensor (2) verbunden ist, um das für den Fehlerstrom (Idf) repräsentative Signal (Is) zu empfangen, und im Ausgang mit einem Kondensator (4) verbunden ist, wobei die Wandlerschaltung (3) dazu eingerichtet ist, das für den Fehlerstrom repräsentative Signal (Is) in eine Kondensatorspannung (V_cap) umzuwandeln und den Kondensator (4) auf diese Kondensatorspannung (V_cap) aufzuladen,
- eine Erkennungsschaltung (5), die mit dem Kondensator (4) verbunden ist, um die Kondensatorspannung (V_cap) an den Klemmen des Kondensators (4) mit einer vorbestimmten Schwellenwertspannung (V_sd) zu vergleichen und einen Steuerausgang (53) zu aktivieren, wenn die Kondensatorspannung (V_cap) an den Klemmen des Kondensators (4) höher als die Schwellenwertspannung (V_sd) ist,
- eine erste Generatorschaltung (6), um einen Teststrom (I_tst1) im Stromsensor (2) zu generieren,
- eine zweite Generatorschaltung (7), um einen Ladestrom (I_tst2) des Kondensators (4) zu generieren,

wobei das Verfahren umfasst:

eine erste Testsequenz (100) zum Testen des Stromsensors (2), der Wandlerschaltung (3) und des Kondensators (4) mittels der ersten Generatorschaltung (6) und, wenn die erste Testsequenz positiv ist, eine zweite Testsequenz (200) zum Testen der Erkennungsschaltung (5) mittels der zweiten Generatorschaltung (7) und zum Aktivieren des Steuerausgangs (53), wenn die zweite Testsequenz positiv ist.

2. Testverfahren nach Anspruch 1, **dadurch gekennzeichnet, dass** die erste Testsequenz (100) umfasst:

- einen Schritt (110) einer ersten Spannungsmessung (V_cap1) an den Klemmen des Kondensators (4),
- einen Schritt (135) des Generierens des Teststroms (I_tst1) im Stromsensor (2) während einer ersten Verzögerungszeit (Tempo_1) und
- einen Schritt (150) einer zweiten Spannungsmessung (V_cap2) an den Klemmen des Kondensators (4).

3. Testverfahren nach Anspruch 2, **dadurch gekennzeichnet, dass** die erste Verzögerungszeit (Tempo_1) so bestimmt wird, dass die zweite Spannungsmessung (V_cap2) geringer als die Schwellenwertspannung (V_sd) ist.

4. Testverfahren nach einem der Ansprüche 2 oder 3, **dadurch gekennzeichnet, dass** die erste Verzögerungszeit (Tempo_1) bestimmt wird in Abhängigkeit:

   - von der ersten Spannungsmessung (V_cap1) an den Klemmen des Kondensators (4),
   - von einem Wert einer vorbestimmten ersten Zielspannung (V_s1),
   - von der Kapazität (C) des Kondensators (4) und
   - von der Amplitude des Teststroms (I_tst1).

5. Testverfahren nach dem vorhergehenden Anspruch, **dadurch gekennzeichnet, dass** der Wert der ersten Zielspannung (V_s1) geringer als die Schwellenwertspannung (V_sd) ist.

6. Testverfahren nach einem der Ansprüche 4 oder 5, **dadurch gekennzeichnet, dass** die erste Verzögerungszeit (Tempo_1) berechnet wird nach der Gleichung:

[Math 6]

$$Tempo\_1 = \frac{(V\_cap1 - V\_s1)\; x\; C}{I\_tst1}$$

worin

   Tempo_1 die erste Verzögerungszeit ist,
   V_cap1 die erste Spannungsmessung an den Klemmen des Kondensators (4) ist,
   V_s1 der Wert der ersten Zielspannung ist,
   C die Kapazität des Kondensators (4) ist und
   I_tst1 die Amplitude des Teststroms ist.

7. Testverfahren nach einem der Ansprüche 2 bis 6, **dadurch gekennzeichnet, dass** die erste Testsequenz (100) positiv ist, wenn die Differenz zwischen der zweiten Spannungsmessung (V_cap2) und der ersten Spannungsmessung (V_cap1) größer als ein vorbestimmter zweiter Schwellenwert (Delta_V) liegt.

8. Testverfahren nach einem der vorhergehenden Ansprüche, **dadurch gekennzeichnet, dass** die zweite Testsequenz (200) einen Schritt (240) des Generierens des Ladestroms (I_tst2) des Kondensators (4) mittels der zweiten Generatorschaltung (7) während einer vorbestimmten zweiten Verzögerungszeit (Tempo_2) umfasst.

9. Testverfahren nach dem vorhergehenden Anspruch, **dadurch gekennzeichnet, dass** die zweite Verzögerungszeit (Tempo_2) bestimmt wird in Abhängigkeit:

   - von der zweiten Spannungsmessung (V_cap2),
   - von einer vorbestimmten zweiten Zielspannung (V_s2),
   - vom Wert der Kapazität (C) des Kondensators (4) und
   - von der Amplitude des Ladestroms (I_tst2) des Kondensators (4).

10. Testverfahren nach dem vorhergehenden Anspruch, **dadurch gekennzeichnet, dass** die zweite Verzögerungszeit (Tempo_2) berechnet wird nach der Gleichung:

[Math 7]

$$Tempo\_2 = \frac{(V\_s2 - V\_cap2)\; x\; C}{I\_tst2}$$

worin

   Tempo_2 die zweite Verzögerungszeit ist,
   V_s2 die zweite Zielspannung ist,
   V_cap2 die zweite Spannungsmessung ist,

C der Wert der Kapazität des Kondensators (4) ist und

I_tst2 die Amplitude des Ladestroms des Kondensators (4) ist.

**11.** Testverfahren nach dem einem der Ansprüche 9 oder 10, **dadurch gekennzeichnet, dass** der Wert der zweiten Zielspannung (V_s2) zwischen dem 1-Fachen und dem 1,2-Fachen der Schwellenwertspannung (V_sd) liegt.

**12.** Schutzgerät (1) eines elektrischen Netzes, wobei das Gerät umfasst:

- einen Stromsensor (2), der ein Signal (Is) abgibt, das für einen elektrischen Fehlerstrom (Idf) repräsentativ ist, der in, mindestens, einem elektrischen Leiter (21) fließt,
- eine Wandlerschaltung (3), die im Eingang mit dem Stromsensor (2) und im Ausgang mit einem Kondensator (4) verbunden ist, wobei die Wandlerschaltung (3) dazu eingerichtet ist, das für den Fehlerstrom repräsentative Signal (Is) in eine Kondensatorspannung (V_cap) umzuwandeln und den Kondensator (4) auf diese Spannung (V_cap) aufzuladen,
- eine Erkennungsschaltung (5), die mit dem Kondensator (4) verbunden ist, um die Kondensatorspannung (V_cap) an den Klemmen des Kondensators (4) mit einer vorbestimmten ersten Schwellenwertspannung (V_sd) zu vergleichen vorbestimmten und einen Steuerausgang (53) zu aktivieren, wenn die Spannung an den Klemmen des Kondensators (4) größer als die Schwellenwertspannung (V_sd) ist,
- eine erste Generatorschaltung (6), um einen Teststrom (I_tst1) im Stromsensor (2) zu generieren,

wobei das Schutzgerät (1) **dadurch gekennzeichnet ist, dass** es umfasst:

- eine Messschaltung (8), die mit dem Kondensator (4) verbunden ist, um die Kondensatorspannung (V_cap) an den Klemmen des Kondensators (4) zu messen,
- eine zweite Generatorschaltung (7), um einen Ladestrom (I_tst2) zum Laden des Kondensators (4) zu generieren, und
- eine Verarbeitungsschaltung (9), die mit der ersten Generatorschaltung (6) verbunden ist, um die Generierung des Teststroms (I_tst1) zu steuern, mit der zweiten Generatorschaltung (7) verbunden ist, um die Generierung des Ladestroms (I_tst2) zu steuern, und mit der Messschaltung (8) verbunden ist, um die Messung der Kondensatorspannung (V_cap) an den Klemmen des Kondensators (4) zu empfangen, wobei die Verarbeitungsschaltung (9) Schaltungen zum Ausführen des Testverfahrens nach einem der Ansprüche 1 bis 11 umfasst.

**13.** Schutzgerät (1) nach dem vorhergehenden Anspruch, **dadurch gekennzeichnet, dass** die Wandlerschaltung (3) einen Ladewiderstand (31) und eine Gleichrichterschaltung (32) für das für den Fehlerstrom (Idf) repräsentative Signal (Is) umfasst.

**14.** Schutzgerät (1) nach einem der Ansprüche 12 oder 13, **dadurch gekennzeichnet, dass** es umfasst:

- einen Stromunterbrecher (12), um den Fluss eines elektrischen Stroms in, mindestens, einem Stromleiter (21) herzustellen oder zu unterbrechen,
- einen Aktor (11), der an den Steuerausgang (53) der Erkennungsschaltung (5) angeschlossen ist, wobei der Aktor (11) das Öffnen des Stromunterbrechers (12) auslöst, wenn der Steuerausgang (53) aktiviert wird.

**15.** Schutzgerät (1) nach einem der Ansprüche 12 bis 14, **dadurch gekennzeichnet, dass** der Stromsensor (2) ein Sensor für den Differenzstrom ist, der in, mindestens, zwei elektrischen Leitern (21) fließt.

**Claims**

**1.** Method for testing the operation of a protection unit (1) for an electrical network, said unit including:

- a current sensor (2) delivering a signal (Is) that is representative of an electric fault current (Idf) flowing through at least one electrical conductor (21);
- a converter circuit (3) that is connected at input to the current sensor (2) so as to receive the signal (Is) that is representative of the fault current (Idf) and connected at output to a capacitor (4), said converter circuit (3) being designed to convert the signal (Is) that is representative of the fault current into a capacitor voltage (V_cap) and to charge the capacitor (4) to said capacitor voltage (V_cap);
- a detection circuit (5) that is connected to the capacitor (4) so as to compare the capacitor voltage (V_cap) across the terminals of the capacitor (4) with a predetermined threshold voltage (V_sd) and to activate a control output (53) when the capacitor voltage (V_cap) across the terminals of the capacitor (4) is higher than the threshold voltage (V_sd);
- a first generator circuit (6) for generating a test current (I_tst1) in the current sensor (2);
- a second generator circuit (7) for generating a current (I_tst2) for charging the capacitor (4),

where the method includes:

a first test sequence (100) for testing the current sensor (2), the converter circuit (3) and the capacitor (4) by means of the first generator circuit (6); and, when the first test sequence is positive,
a second test sequence (200) for testing the detection circuit (5) by means of the second generator circuit (7) and for activating the control output (53) when the second test sequence is positive.

2. Test method according to Claim 1, **characterized in that** the first test sequence (100) includes:

- a step (110) of taking a first measurement (V_cap1) of the voltage across the terminals of the capacitor (4);
- a step (135) of generating the test current (I_tst1) in the current sensor (2) during a first delay (Tempo_1); and
- a step (150) of taking a second measurement (V_cap2) of the voltage across the terminals of the capacitor (4).

3. Test method according to Claim 2, **characterized in that** the first delay (Tempo_1) is determined such that the second measurement of the (V_cap2) voltage is lower than the threshold voltage (V_sd).

4. Test method according to either of Claims 2 and 3, **characterized in that** the first delay (Tempo_1) is determined according to:

- the first measurement (V_cap1) of the voltage across the terminals of the capacitor (4);
- a value of a predetermined first target voltage (V_s1);
- the capacitance (C) of the capacitor (4); and
- the amplitude of the test current (I_tst1).

5. Test method according to the preceding claim, **characterized in that** the value of the first target voltage (V_s1) is lower than the threshold voltage (V_sd).

6. Test method according to either of Claims 4 and 5, **characterized in that** the first delay (Tempo_1) is calculated according to the equation:

[Math 6]

$$Tempo\_1 \; = \frac{(V\_cap1 \; - \; V\_s1) \; x \; C}{I\_tst1}$$

wherein:

Tempo_1 is the first delay;
V_cap1 is the first measurement of the voltage across the terminals of the capacitor (4);
V_s1 is the value of the first target voltage;
C is the capacitance of the capacitor (4); and
I_tst1 is the amplitude of the test current.

7. Test method according to any one of Claims 2 to 6, **characterized in that** the first test sequence (100) is positive when the difference between the second voltage measurement (V_cap2) and the first voltage measurement (V_cap1) is higher than a predetermined second threshold (Delta_V).

8. Test method according to any one of the preceding claims, **characterized in that** the second test sequence (200) includes a step (240) of generating the current (I_tst2) for charging the capacitor (4) by means of the second generator circuit (7) during a predetermined second delay (Tempo_2).

9. Test method according to the preceding claim, **characterized in that** the second delay (Tempo_2) is determined according to:

   - the second voltage measurement (V_cap2);
   - a predetermined second target voltage (V_s2);
   - the value of the capacitance (C) of the capacitor (4); and
   - the amplitude of the current (I_tst2) for charging the capacitor (4).

10. Test method according to the preceding claim, **characterized in that** the second delay (Tempo_2) is calculated according to the equation:

[Math 7]

$$Tempo\_2 \ = \frac{(V\_s2 \ - \ V\_cap2) \ x \ C}{I\_tst2}$$

wherein:

   Tempo_2 is the second delay;
   V_s2 is the second target voltage;
   V_cap2 is the second voltage measurement;
   C is the value of the capacitance of the capacitor (4); and
   I_tst2 is the amplitude of the current for charging the capacitor (4).

11. Test method according to either of Claims 9 and 10, **characterized in that** the value of the second target voltage (V_s2) is between 1 and 1.2 times the threshold voltage (V_sd).

12. Protection unit (1) for an electrical network, said unit including:

   - a current sensor (2) delivering a signal (Is) that is representative of an electric fault current (Idf) flowing through at least one electrical conductor (21);
   - a converter circuit (3) that is connected at input to the current sensor (2) and at output to a capacitor (4), said converter circuit (3) being designed to convert the signal (Is) that is representative of the fault current into a capacitor voltage (V_cap) and to charge said capacitor (4) to said voltage (V_cap);
   - a detection circuit (5) that is connected to the capacitor (4) so as to compare the capacitor voltage (V_cap) across the terminals of the capacitor (4) with a predetermined first threshold voltage (V_sd) and to activate a control output (53) when the voltage across the terminals of the capacitor (4) is higher than the threshold voltage (V_sd);
   - a first generator circuit (6) for generating a test current (I_tst1) in the current sensor (2);

   said protection unit (1) being **characterized in that** it includes:

   - a measurement circuit (8) that is connected to the capacitor (4) so as to measure the capacitor voltage (V_cap) across the terminals of the capacitor (4);
   - a second generator circuit (7) for generating a charging current (I_tst2) for charging the capacitor (4); and
   - a processing circuit (9) that is connected to the first generator circuit (6) so as to control the generation of the test current (I_tst1), which is connected to the second generator circuit (7) so as to control the generation of the charging current (I_tst2) and is connected to the measurement circuit (8) so as to receive the measurement of the capacitor voltage (V_cap) across the terminals of the capacitor (4), said processing circuit (9) including circuits for running the test method according to one of Claims 1 to 11.

13. Protection unit (1) according to the preceding claim, **characterized in that** the converter circuit (3) includes a load resistor (31) and a rectifier circuit (32) for the signal (Is) that is representative of the fault current (Idf).

14. Protection unit (1) according to either of Claims 12 and 13, **characterized in that** it includes:

   - a current switch (12) for establishing or for interrupting the flow of an electric current through at least one current conductor (21);
- an actuator (11) that is connected to the control output (53) of the detection circuit (5), said actuator (11) actuating the opening of the current switch (12) when the control output (53) is activated.

**15.** Protection unit (1) according to any one of Claims 12 to 14, **characterized in that** the current sensor (2) is a sensor for a differential current flowing through at least two electrical conductors (21).

[Fig 1]

[Fig 2]

EP 3 650 875 B1

[Fig 3A]

Début

110 — Mesure V_cap_1

115 — V_cap_1 > V_ct
Non / Oui

Calcul Tempo_1 — 125

120 — Tempo_1 = T1

130 — t = 0

135 — Génération I_tst1
t = t +1

140 — t > Tempo_1
Non / Oui

Vers étape 145

19

[Fig 3B]

145 → Stop I_tst1

150 → Mesure V_cap_2

160 → Calcul Delta_V

170 → (V_cap_2)- (V_cap_1) ≈ Delta_V ?

Non

Oui

180 → Test négatif

Vers étape 210
(Sequence 2)

**[Fig 3C]**

210 — Calcul Tempo_2

220 — t = 0

230 — Génération I_tst2
t = t +1

240 — Sortie activée ?

Non

Oui

250 — Test positif

260 — t > Tempo_2

Non

Oui

270 — Stop I_tst2

280 — Test négatif

[Fig 4]

[Fig 5]

[Fig 6]

## RÉFÉRENCES CITÉES DANS LA DESCRIPTION

**Documents brevets cités dans la description**

- US 5371646 A
- EP 1936771 A1
- FR 1755699
- US 2009040666 A1
- US 2012154957 A1